# EUROPÄISCHE PATENTANMELDUNG

(11) **EP 2 910 903 A1**
(43) Veröffentlichungstag der Anmeldung: **26.08.2015**
(21) Anmeldenummer: 14155915.3
(22) Anmeldetag: 20.02.2014
(51) Int. Cl.: G01D 4/02, G01R 22/06

(54) **Verfahren zum Erkennen von Stromdiebstahl in einem Niederspannungsnetz**

(71) Anmelder: Siemens Aktiengesellschaft, 80333 München (DE)
(72) Erfinder: Abart, Andreas, 4810 Gmunden (AT); Pitz, Richard, 1040 Wien (AT)
(74) Vertreter: Maier, Daniel Oliver

(57) **Zusammenfassung**

Die Erfindung betrifft ein Verfahren zum Erkennen von Stromdiebstahl (uN) in einem Niederspannungsnetz (NN), in welchem jedem bekannten Netzteilnehmer (N1 bis N5) eine intelligente Messeinheit (M1 bis M5) zugeordnet ist. Dabei ist in zumindest einem Verteilerknoten (VK) eine Strommesseinheit (SE) installiert. Weiterhin werden die zumindest eine Strommesseinheit (SE) und die intelligenten Messeinheiten (M1 bis M5) von einer zentralen Kontrolleinheit (KE) überwacht. Von der Strommesseinheit (SE) werden auftretende Stromänderungen erfasst und mit einem vordefinierten Schwellwert verglichen (1). Wird der vordefinierte Schwellwert überschritten, so wird von der Strommesseinheit (SE) eine Meldung an die zentrale Kontrolleinheit (KE) gesendet (2), von welcher dann für einen Zeitpunkt, an welchem die Stromänderung von der Strommesseinheit (SE) festgestellt worden ist, an den entsprechenden, intelligenten Messeinheiten (M1 bis M5) gemessene Stromänderungen abgefragt werden (3). Die Summe der von den intelligenten Messeinheiten (M1 bis M5) gemessenen Stromänderungen wird dann mit der von der Strommesseinheit (SE) festgestellten Stromänderung verglichen (4) und bei einer Abweichung dieser Summe von der durch die Stromesseinheit (SE) festgestellten Stromänderung werden weiterführende Analysemaßnahmen wie z.B. ein Abfragen von Spannungsänderungen an den Messeinheiten (M1 bis M5), etc. eingeleitet (5, 6). Das erfindungsgemäße Verfahren erlaubt auf einfache Weise und ohne großen zusätzlichen technischen Aufwand ein Erkennen und Lokalisieren eines Stromdiebstahls (uN).

## Beschreibung

### Technisches Gebiet

Die Erfindung betrifft allgemein das Gebiet der Energieversorgung bzw. der Energieversorgungssysteme. Im Speziellen bezieht sich die vorliegende Erfindung auf ein Verfahren zum Erkennen von Stromdiebstahl in einem Niederspannungsnetz. In diesem Niederspannungsnetz ist jedem bekannten Netzteilnehmer eine intelligente Messeinheit, ein so genannter Smart Meter, zugeordnet. Die intelligenten Messeinheiten sind dabei Verteilerknoten im Niederspannungsnetz zugeordnet bzw. von diesen erreichbar und in zumindest einem Verteilerknoten des Niederspannungsnetzes ist eine Strommesseinheit installiert. Dabei werden die zumindest eine Strommesseinheit und die intelligenten Messeinheiten von einer zentralen Kontrolleinheit überwacht.

### Stand der Technik

Die Versorgung von dezentral angeordneten Netzteilnehmern mit elektrischer Energie erfolgt üblicherweise über ein Energieversorgungssystem, welches meist aus mehreren - üblicherweise drei - Versorgungsebenen besteht. Über das Energieversorgungssystem wird die elektrische Energie von Energieerzeugern wie z.B. Kraftwerksbetreibern, etc. zu den Netzteilnehmern bzw. Verbrauchern (z.B. Geräten in Industrieunternehmen, Haushalte, etc.) transportiert und verteilt. Für den Transport und die Verteilung der elektrischen Energie sind üblicherweise die Versorgungsebenen vorgesehen, welche unterschiedlich festgelegte Spannungsbereiche aufweisen und nach diesen Spannungsbereichen eingeteilt werden. Üblicherweise wird ein Energieversorgungssystem in eine Hochspannungsebene, eine Mittelspannungsebene und in eine Niederspannungsebene eingeteilt.

Für eine Feinverteilung der elektrischen Energie an die Netzteilnehmer bzw. Verbraucher sind die so genannte Niederspannungsebene oder die so genannten Niederspannungsnetze bzw. Ortsnetze vorgesehen. Ein Niederspannungsnetz wird über einen Verteilerknoten bzw. eine Transformatorstation regional oder lokal aus der übergeordneten Mittelspannungsebene bzw. aus einem übergeordneten Mittelspannungsnetz gespeist. Niederspannungsnetze sind üblicherweise ausgehend von einem Bereich der Hauptverteilung in mehrere Abzweige (z.B. Kabelstränge) unterteilt, über welche dann die einzelnen Netzteilnehmer (z.B. kleiner Industrieanlagen, Haushalte, Häuser, Hausanlagen, etc.) oder Gruppen von Netzteilnehmern (z.B. Wohngebäude, Häusergruppen, etc.) mit elektrischer Energie versorgt werden. Für Gruppen von Netzteilnehmer wie z.B. Gebäudeeinheiten, Gebäudekomplexe, Gruppen von Haushalten, etc. können im Niederspannungsnetz z.B. bei Abzweigen weitere Verteilerknoten in Form vom Verteilereinheiten vorgesehen sein. In derartigen Verteilerknoten wie z.B. Transformatorstationen, Verteilereinheiten, etc. können für Strommessungen, etc. Strommesseinheiten installiert sein.

Um die an die jeweiligen Netzteilnehmer gelieferte elektrische Energie ermitteln zu können, wird üblicherweise jedem Netzteilnehmer einen Messeinheit - ein so genannter Zähler - zugeordnet. Durch diese Zuordnung ist der Netzteilnehmer im Energieversorgungssystem bzw. beim Energieversorger bekannt und es kann der jeweilige Verbrauch des Netzteilnehmers mit Hilfe der Messeinheit bestimmt werden. Heutzutage können für die Verbrauchsermittlung beispielsweise intelligente Messeinheiten - so genannte Smart Meter - eingesetzt werden. Eine intelligente Messeinheit oder Smart Meter ist ein mit Zusatzfunktonen ausgestattete, elektronische Messeinheit, welche üblicherweise einen Verbrauch eines Netzteilnehmers in Form eines Zählerstandes erfasst und z.B. Messdaten elektronisch (z.B. via Internet, via Powerline Communication, etc.) an den Energieversorger bzw. -anbieter übermitteln kann. Weiterhin können durch diese intelligenten Messeinheiten beispielsweise durch Zusatzfunktionen weitere Messwerte (z.B. Stromwerte, Spannungswerte, etc.) erfasst und elektronisch übermittelt werden. Für eine Überwachung der intelligenten Messeinheiten und eine Kommunikation und/oder Übertragung von Messdaten der intelligenten Messeinheiten an z.B. ein Zentralsystem beim Energieversorger wird beispielsweise eine zentrale Kontrolleinheit für das jeweilige Niederspannungsnetz angebracht. Durch diese zentrale Kontrolleinheit, welche auch als Datenkonzentrator bezeichnet wird, werden z.B. die von jenen intelligenten Messeinheiten und damit Netzteilnehmern gelieferten Daten gesammelt, welche z.B. im jeweiligen Niederspannungsnetz installiert und damit der zentralen Kontrolleinheit bekannt sind. Die gesammelten Daten werden dann üblicherweise von der zentralen Kontrolleinheit gebündelt an das Zentralsystem beim Energieversorger weitergeleitet.

Eine nicht autorisierte Entziehung elektrischer Energie, welche umgangssprachlich auch als Stromdiebstahl bezeichnet wird, ist ein z.B. im deutschen Strafgesetzbuch normiertes Vergehen. Ein Stromdiebstahl kann z.B. vorgenommen werden, indem an eine physikalisch geeignete Stromleitung ein Verbraucher als für den Energieversorger unbekannter Netzteilnehmer angeschlossen wird. Dazu kann beispielsweise eine Stromleitung (bzw. ein Abzweig) im Vorzählerbereich bzw. vor einer intelligenten Messeinheit im Niederspannungsnetz installiert werden, über welche elektrische Energie bzw. Strom aus dem Niederspannungsnetz abgenommen wird. Ein so gearteter Diebstahl ist schwer zu entdecken und geht für den jeweiligen Energieversorger mit großen Verlusten einher. In manchen Ländern kann ein Verlust durch einen derartigen Stromdiebstahl z.B. bis zu 40% betragen. Selbst in einigen entwickelten Ländern können beispielsweise Verluste durch Stromdiebstahl von 15% bis 20% möglich sein.

Ein Erkennen, eine Aufklärung und/oder Verhinderung von derartigen Stromdiebstählen ist meist schwierig und oft nur mit großem Aufwand möglich. So können beispielsweise mit einem hohen personellen Aufwand regelmäßige Überprüfungen von intelligenten Messeinheiten und Abzweigen bzw. Stromleitungen durchgeführt werden oder z.B. bei einem konkreten Verdacht ein Netzteilnehmer oder eine Anlage geprüft werden. Intelligente Messeinheiten sind beispielsweise bereits zur Absicherung gegen Manipulation an der Messeinheit selbst oder Fremdfeldeinwirkungen mit entsprechenden Sensoren ausgestattet. Allerdings sind Lösungen zur Erkennung von Manipulationen im Bereich der Messeinheit meist nicht ausreichend, um Stromdiebstahl z.B. mittels eines Abzweigs im Vorzählerbereich festzustellen.

Aus der Schrift DE 10 2009 042 330 A1 ist eine Vorrichtung wie ein Verfahren zum automatisierten Erkennen von Stromdiebstahl bekannt. Bei dem in dieser Schrift beschriebenen Verfahren wird mit Hilfe von intelligenten Zählern ein Stromverbrauch der jeweiligen Netzteilnehmer gemessen und ermittelt und mit einem in einer Transformatorstation gemessen Stromverbrauch verglichen. Ist eine Summe des bei den Netzteilnehmern ermittelten Stromverbrauchs um mindestens einen vorgegebenen Verbrauchswert geringer als der in der Transformatorstation gemessene Stromverbrauch, so wird eine Fehlermeldung ausgelöst. Allerdings werden durch eine kontinuierliche oder periodische Abfrage der Stromverbrauchswerte der Netzteilnehmer sowie des Stromverbrauchs in der Transformatorstation große Datenmengen generiert, welche für das Erkennen eines Stromdiebstahls laufend ausgewertet und analysiert werden müssen. Weiterhin werden die Stromverbrauchswerte von intelligenten Zählern an der Transformatorstation nicht zeitsynchron ermittelt. Damit können beispielsweise Einschaltstromspitzen von illegalen angeschlossenen Verbrauchern nicht erkannt werden. Durch einen Vergleich von Stromverbrauchswerten sind weiterhin eine Einschränkung des Ortes eines Stromdiebstahls und/oder eine Lokalisierung des Stromdiebstahls nur sehr schwer möglich. Durch das in der Schrift DE 10 2009 042 330 A1 beschriebene Verfahren kann ein Stromdiebstahl in einem Niederspannungs- oder Ortsnetz zwar erkannt werden, eine Lokalisierung ist aber weiterhin mit nur mit relativ hohem technischen und/oder personellen Aufwand möglich.

### Darstellung der Erfindung

Der Erfindung liegt daher die Aufgabe zugrunde, ein Verfahren anzugeben, durch welches auf einfache und effiziente Weise und ohne großen Aufwand ein Entziehen von elektrischer Energie aus einem Niederspannungsnetz, ein so genannter Stromdiebstahl, rasch erkannt und lokalisiert werden kann.

Diese Aufgabe wird durch ein Verfahren der eingangs angeführten Art mit den Merkmalen gemäß dem unabhängigen Patentanspruch gelöst. Vorteilhafte Ausführungsformen der vorliegenden Erfindung sind in den abhängigen Ansprüchen beschrieben.

Erfindungsgemäß erfolgt die Lösung der Aufgabe mit einem Verfahren der eingangs erwähnten Art, bei welchem von zumindest einer Strommesseinheit, welche in einem Verteilerknoten des Niederspannungsnetzes installiert worden ist, auftretende Stromänderungen laufend erfasst und mit einem vordefinierten Schwellwert verglichen werden. Wird von der zumindest einen Strommesseinheit ein Überschreiten des Schwellwertes durch eine Stromänderung festgestellt, so wird von der Strommesseinheit eine Meldung an die zentrale Kontrolleinheit gesendet. Dann werden von der zentralen Kontrolleinheit für einen Zeitpunkt, an welchem die Stromänderung von der zumindest einen Strommesseinheit festgestellt worden ist, Stromänderungen an den entsprechenden, intelligenten Messeinheiten abgefragt werden - d.h. an jenen intelligenten Messeinheiten, welche dem jeweiligen Verteilerknoten mit der Strommesseinheit, an welcher die Stromänderung über dem Schwellwert festgestellt worden ist, zugeordnet sind bzw. von diesem erreichbar sind. Dann wird von der zentralen Kontrolleinheit die von der zumindest einen Strommesseinheit festgestellte Stromänderung mit einer Summe der von den entsprechenden, intelligenten Messeinheiten gemessenen Stromänderungen verglichen. Wird bei diesem Vergleich eine Abweichung dieser Summe von der durch die zumindest eine Strommesseinheit festgestellte Stromänderung festgestellt, so werden weiterführende Analysemaßnahmen eingeleitet.

Der Hauptaspekt der erfindungsgemäß vorgeschlagenen Lösung besteht drin, dass durch das erfindungsgemäße Verfahren eine vergleichbare, diskrete Ermittlung von Stromdiebstählen in einem Niederspannungsnetz ermöglicht wird. Ein zusätzlicher technischer Aufwand für eine Durchführung des erfindungsgemäßen Verfahrens in einem Niederspannungsnetz beschränkt sich auf eine Installation und/oder eine Integration einer Strommesseinheit in einem oder mehreren Verteilerknoten des Niederspannungsnetz bzw. eine Erweiterung einer vorhandenen Strommesseinheit in einem oder mehreren Verteilerknoten, sodass von dieser laufend auftretende Stromänderungen erfasst werden können. Von der Strommesseinheit können zu jedem Zeitpunkt sprunghafte Stromänderungen durch einen Schwellwertvergleich festgestellt werden und an die zentrale Kontrolleinheit für das Niederspannungsnetz gemeldet werden. Nur in diesem Fall werden von der zentralen Kontrolleinheit Stromänderungen an den intelligenten Messeinheiten für jenen Zeitpunkt abgefragt, zu welchem eine sprunghafte Stromänderung von der Strommesseinheit festgestellt worden ist. Diese Daten werden dann der zentralen Kontrolleinheit ausgewertet und verglichen. Damit wird die zu übertragende und auszuwertende Datenmenge möglichst gering gehalten. Abweichungen beim Vergleich liefern dann einen eindeutigen Indikator für einen Stromdiebstahl, da ohne unbekannten bzw. unberechtigten Netzteilnehmer jede an der Strommesseinheit festgestellte, sprunghafte Stromänderung auch an einem oder mehreren intelligenten Messeinheiten im Niederspannungsnetz ersichtlich sein muss.

Weiterhin werden jene Stromänderungen an den intelligenten Messeinheiten und in einem Verteilerknoten verglichen, welche zum selben Zeitpunkt aufgetreten sind. Auf diese Weise können auch Einschaltstromspitzen, welche z.B. durch einen nicht legalen Netzteilnehmer verursacht werden, erkannt werden. Ausreichend große Stromänderungen (z.B. > 3 Ampere), welche nicht zugeordnet werden können (d.h. die Summe der Stromänderungen an den intelligenten Messeinheit weicht von der mit der Strommesseinheit gemessenen Stromänderung ab), können dann als eindeutiger Indikator für einen unberechtigten Energie- oder Strombezug gewertet werden. Durch weitere Analysemaßnahmen kann dann der Ort oder der Bereich des Stromdiebstahls im Niederspannungsnetz eingrenzt werden und leicht und mit geringen Aufwand aufgefunden werden. Weiterhin kann das erfinderische Verfahren auch dazu genutzt werden, um z.B. defekte Messeinheiten zu erkennen - unter der Voraussetzung, dass alle Messeinheiten dem jeweiligen Verteilerknoten (z.B. Transformatorstation, Verteilereinheit, etc.) zugeordnet und von diesem erreichbar sind.

Es ist dabei auch von Vorteil, wenn die zumindest eine Strommesseinheit und die intelligenten Messeinheiten mit der Hilfe der zentralen Kontrolleinheit zeitlich synchronisiert werden. Durch eine zeitliche Synchronisation der intelligenten Messeinheiten und der Strommesseinheit wird sichergestellt, dass von der Strommesseinheit festgestellte und von den Messeinheiten abgefragte Stromänderungen für denselben Zeitpunkt in der Kontrolleinheit verglichen werden. Für die zeitliche Synchronisation der intelligenten Messeinheiten und der Strommesseinheit kann von der zentralen Kontrolleinheit beispielswiese eine Zeitinformation über das Stromnetz als Kommunikationsmittel (z.B. mit Powerline Communication oder PLC) verteilt werden. Diese Zeitinformation wird von der zentralen Kontrolleinheit z.B. über Funk, GPS oder mittels Fernkommunikation erhalten.

Weiterhin ist es günstig, wenn von der Meldung, welche von der zumindest einen Strommesseinheit an die zentrale Kontrolleinheit gesendet wird, zumindest Informationen über die festgestellte Stromänderung (wie z.B. Höhe der Änderung, etc.) sowie über den Zeitpunkt der festgestellten Stromänderung - beispielsweise in Form eines Zeitstempels - umfasst werden. Durch diese Informationen sind der Kontrolleinheit ein Wert der von der Strommesseinheit festgestellten Stromänderungen sowie der Zeitpunkt bekannt, an welchem diese Stromänderung im Verteilerknoten aufgetreten und festgestellt worden ist. Von der zentralen Kontrolleinheit können damit für genau diesen Zeitpunkt die intelligenten Messeinheiten bei den bekannten Netzteilnehmern nach gemessenen Stromänderungen abgefragt werden und jene intelligenten Messeinheiten, von welchen zu diesem Zeitpunkt eine Stromänderung festgestellt worden ist, können diese an die zentrale Messeinheit zurückmelden. Dadurch wird eine zu übertragenden und auszuwertende Datenmenge gering gehalten und es ist eine zeitgenaue Auswertung von Stromänderungen sehr einfach möglich. Einschaltstromspitzen von nicht berechtigten Netzteilnehmern bzw. nicht legal an das Niederspannungsnetz angeschlossenen Verbrauchern können damit sehr einfach festgestellt werden.

Eine zweckmäßige Weiterbildung des erfindungsgemäßen Verfahrens sieht vor, dass als weiterführende Analysemaßnahme von der zentralen Kontrolleinheit an den entsprechenden, intelligenten Messeinheiten für den Zeitpunkt der von der zumindest einen Strommesseinheit festgestellten Stromänderung auch Spannungsänderungen abgefragt werden. Durch ein Abfragen der Spannungsänderungen an den intelligenten Messeinheiten, welche dem jeweiligen Verteilerknoten mit der jener Strommesseinheit, von welche die Stromänderungen festgestellt worden ist, zugeordnet sind, kann auf einfache Weise eine Eingrenzung auf z.B. einen Abzweig bis hin zur eindeutigen Feststellung des Ortes des Stromdiebstahls ermöglicht werden. Dabei ist es vorteilhaft, wenn eine Verteilung der von den intelligenten Messeinheiten festgestellten Spannungsänderungen in einem Auswertesystem analysiert wird. Durch einen Strom- bzw. Lastsprung - d.h. einen sprunghafte Stromänderung - kommt es auch zu einer Änderung der Spannung. Durch die Höhe der Spannungsänderung, welche von den intelligenten Messeinheiten im Niederspannungsnetz ermittelt werden kann, kann der Ort, an welchem diese Stromänderung aufgetreten ist, z.B. durch eine Auswertung der Verteilung der Spannungsänderungen in einem Auswertsystem eingegrenzt werden. Der Ort eines möglichen Stromdiebstahls kann damit rascher und zielgerichteter mit geringerem personellen Aufwand entdeckt werden.

Idealer Weise wird für eine Kommunikation und/oder Datenübertragung zwischen den intelligenten Messeinheiten, der zumindest einen Strommesseinheit und der zentralen Kontrolleinheit das Niederspannungsnetz als Kommunikationsmedium für insbesondere eine so genannte Powerline Communication oder PLC eingesetzt. Bei der Nutzung des Niederspannungsnetzes als Kommunikationsmedium, insbesondere bei Powerling Communication oder PLC, werden das vorhandene Stromnetz und dessen Leitungen zum Aufbau eines Kommunikationsnetzes und zur Übertragung von Informationen und Daten zwischen den Einheiten genutzt. Dabei muss idealer Weise für das Erkennen von Stromdiebstählen bzw. für die Kommunikation und die zeitliche Synchronisation zwischen der zumindest einen Strommesseinheit, den intelligenten Messeinheiten und der zentralen Kontrolleinheit kein zusätzliches Kommunikationsmedium installiert werden, sondern es wird das Niederspannungsnetz selbst zur Übertragung von Informationen, Meldungen, Daten, etc. genutzt.

Als Verteilerknoten, in welchen eine Strommesseinheit installiert wird, werden bevorzugter Weise Transformatorstationen und/oder Verteilereinheiten - z.B. bei größeren Gebäudeeinheiten oder - komplexen mit mehreren oder einer Vielzahl an Netzteilnehmern - verwendet. In einer Transformatorstation wird elektrische Energie aus einem Mittelspannungsnetz auf das in Niederspannungsnetzen bzw. Ortsnetzen verwendete Spannungsniveau zur Versorgung der an dieses Niederspannungs- oder Ortsnetz angeschlossenen Netzteilnehmer transformiert. Bei einer Installation einer Strommesseinheit in einer Transformatorstation können sprunghafte Stromänderungen in gesamten angeschlossenen Niederspannungsnetz erfasst werden und damit das gesamte durch die Transformatorstation versorgte Niederspannungsnetz im Bezug auf Stromdiebstähle überwacht werden. Für einen genauere Überwachung bzw. einfacher Feststellung von Stromdiebstählen können auch in den im Niederspannungsnetz angebrachten Verteilereinheiten Strommesseinheiten angebracht werden. Damit können beispielsweise sehr einfach die an diese Verteilereinheiten angeschlossenen Abzweige (bzw. Kabelstränge) zur Versorgung von Netzteilnehmer-Gruppen, etc. auf sprunghafte Stromänderungen kontrolliert werden und ein Bereich eines möglichen Stromdiebstahl noch genauer eingegrenzt werden.

### Kurzbeschreibung der Zeichnung

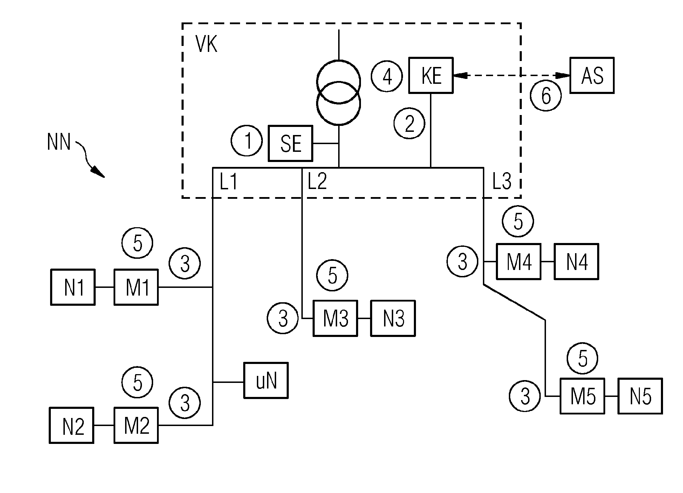

Die Erfindung wird nachfolgend in beispielhafter Weise anhand der beigefügten Figur erläutert. Figur 1 zeigt dabei schematisch und in beispielhafter Weise einen Ablauf des erfindungsgemäßen Verfahrens zum Erkennen eines Stromdiebstahls in einem Niederspannungsnetz.

### Ausführung der Erfindung

Figur 1 zeigt in schematischer Weise ein beispielhaftes Niederspannungsnetz NN. Dieses Niederspannungsnetz NN umfasst einen beispielhaften Verteilerknoten VK wie z.B. eine Transformatorstation, durch welche elektrische Energie bzw. elektrischer Strom aus einem Mittelspannungsnetz auf ein Spannungsniveau des Niederspannungsnetzes NN transformiert wird. Im Verteilerknoten VK ist weiterhin eine Strommesseinheit SE installiert, von welcher z.B. ein Summenstrom im Verteilerknoten VK sowie Stromänderungen im Verteilerknoten VK gemessen werden können. Im Niederspannungsnetz NN können allerdings weitere Verteilerknoten VK wie z.B. Verteilereinheiten zum Anschluss von Gebäudekomplexen, Häusergruppen, etc. vorgesehen sein. Dabei ist es auch möglich für den Ablauf des erfindungsgemäßen Verfahrens auch in diesen Verteilereinheiten Strommesseinheiten SE zu installieren und damit den jeweils zur Verteilereinheit gehörenden Abzweig des Niederspannungsnetzes NN bzw. die zu dieser Verteilereinheit zugeordneten Netzteilnehmer auf Stromdiebstahl zu überwachen.

Weiterhin ist im beispielhaft dargestellten Verteilerknoten VK bzw. der beispielhaften Transformatorstation VK eine zentrale Kontrolleinheit KE z.B. eines Zählerfernabfrage- oder Smart Metering-Systems - ein so genannter Datenkonzentrator - angeordnet. Von der zentralen Kontrolleinheit KE werden die zumindest eine im Niederspannungsnetz NN installierte Strommesseinheit sowie im Niederspannungsnetz befindliche intelligente Messeinheiten M1 bis M5 überwacht und gesteuert. Von der zentralen Kontrolleinheit KE können mit der zumindest einen Strommesseinheit SE und mit den intelligenten Messeinheiten M1 bis M5 über Nachrichten oder Meldungen kommuniziert werden und es können Daten übertragen werden. Dazu kann beispielsweise für eine Datenübertragung, Kommunikation zwischen den Einheiten KE, SE, M1 bis M5, etc. das Niederspannungsnetz NN selbst als Kommunikationsmedium genutzt werden und die Nachrichten, Meldungen, Daten, etc. mittels so genannter Powerline Communication oder PLC ausgetauscht werden.

Weiterhin kann über die zentrale Kontrolleinheit KE eine zeitliche Synchronisation der zumindest einen Strommesseinheit SE mit den intelligenten Messeinheiten M1 bis M5 erfolgen. Damit können Messwerte von z.B. Strom, Stromänderungen, Spannungsänderungen, etc. für bestimmte Zeitpunkte von der zentralen Kontrolleinheit KE bei der zumindest eine Strommesseinheit SE und den intelligenten Messeinheiten M1 bis M5 abgefragt werden. Die zeitliche Synchronisation kann beispielsweise ebenfalls mittels Powerline Communication durchgeführt werden. Von der zentralen Kontrolleinheit KE wird dazu z.B. mittels Funkkommunikation oder über GPS eine Zeitinformation erhalten und dann z.B. über Powerline Communication im Niederspannungsnetz NN verteilt.

Das beispielhaft dargestellte Niederspannungsnetz NN weist weiterhin drei beispielhafte Leitungsstränge bzw. Abzweige L1 bis L3 auf. Über die Abzweige L1 bis L3 werden die Netzteilnehmer N1 bis N5 an das Niederspannungsnetz NN angebunden und mit elektrischer Energie versorgt. Jedem Netzteilnehmer N1 bis N5 ist dabei eine intelligente Messeinheit M1 bis M5 zugeordnet, über welche beispielsweise ein Energieverbrauch des jeweiligen Netzteilnehmers N1 bis N5 ermittelt werden kann. Die Netzteilnehmer N1 bis N5 sind dabei im Niederspannungsnetz bzw. beim jeweiligen Energieversorger bekannt. In einem ersten Leitungsstrang bzw. Abzweig L1 ist allerdings vor einer intelligenten Messeinheit M2 ein Netzteilnehmer bzw. Verbraucher illegal an das Niederspannungsnetz angeschlossen. Der Energieverbrauch dieses illegalen Verbrauchers uN kann damit nicht von einer intelligenten Messeinheit M1 bis M5, insbesondere von jener Messeinheit M2, in deren Nähe er angeschlossen worden ist, erfasst werden (Stromdiebstahl). Da dem illegal angeschlossen Verbraucher uN auch keine intelligente Messeinheit M1 bis M5 zugeordnet ist, ist der Verbraucher uN im Niederspannungsnetz unbekannt und kann unberechtigt Strom beziehen.

Zum Erkennen eines Stromdiebstahls - beispielsweise durch den illegal angeschlossenen Verbraucher uN - werden in einem ersten Verfahrensschritt 1 von der zumindest einen Strommesseinheit SE, welche im Verteilerknoten VK installiert ist, laufend auftretende Stromänderungen erfasst und auf sprunghafte Änderungen überprüft. Dazu werden die erfassten Stromänderungen von Strommesseinheit SE mit einem vordefinierten Schwellwerte (z.B. 3 Ampere, etc.) verglichen. Wird dieser Schwellwert von einer erfassten Stromänderung überschritten, so wird in einem zweiten Verfahrensschritt 2 von der Strommesseinheit SE eine Meldung an die zentrale Kontrolleinheit KE gesendet. In dieser Meldung können zumindest Information über die festgestellte Stromänderung (z.B. Höhe der Stromänderung, etc.) sowie ein Zeitpunkt (z.B. in Form eines Zeitstempels) des Auftretens der Stromänderung hinterlegt sein.

Von der zentralen Kontrolleinheit KE werden dann in einem dritten Verfahrensschritt 3 die entsprechenden intelligenten Messeinheiten M1 bis M5 - d.h. jene Messeinheiten M1 bis M5, welche dem jeweiligen Verteilerknoten VK mit jener Strommesseinheit SE zugeordnet sind, von welcher eine sprunghafte Stromänderung festgestellt worden ist, - nach gemessenen Stromänderungen abgefragt, welche an jenem Zeitpunkt aufgetreten sind, an welchem die sprunghafte Stromänderung von der Strommesseinheit SE festgestellt worden ist. Von jenen intelligenten Messeinheiten M1 bis M5, von welchen eine Stromänderung zu diesem Zeitpunkt gemessen worden ist, wird dann die jeweilige Stromänderung an die zentrale Kontrolleinheit z.B. via Powerline Communication zurückgemeldet. In einem vierten Verfahrensschritt 4 wird dann von der zentralen Kontrolleinheit KE eine Summe der von den Messeinheiten M1 bis M5 gemeldeten Stromänderungen mit der von der Strommesseinheit SE festgestellten Stromänderung verglichen. Ohne unberechtigten Strombezug bzw. Stromdiebstahl sollte die Summe mit der von der Strommesseinheit SE festgestellten Stromänderung gut übereinstimmten bzw. von dieser kaum abweichen, da ein Energieverbrauch und damit auch Stromänderungen bei allen bekannten Netzteilnehmern N1 bis N5 erfasst werden.

Wird im vierten Verfahrensschritt 4 von der zentralen Kontrolleinheit KE allerdings eine Abweichung zwischen der Summe der von den intelligenten Messeinheiten M1 bis M5 gemeldeten Stromänderungen und der von der Strommesseinheit festgestellten Stromänderung festgestellt, so liegt ein eindeutiger Indikator für einen Stromdiebstahl im Niederspannungsnetz NN vor. Gegebenenfalls kann auch eine der intelligenten Messeinheiten M1 bis M5 defekt sein und damit einen falschen Wert liefern. Voraussetzung, dass die nicht zuordenbare Stromänderung als Indikator herangezogen werden kann, ist, dass alle Messeinheiten M1 bis M5 dem Verteilerknoten VK zugeordnet und erreichbar sind.

Im ersten Abzweig L1 ist beispielsweise der Verbraucher uN illegal angeschlossen und sein Verbrauch wird durch keine intelligente Messeinheit M1 bis M5 erfasst. Wird dieser Verbraucher uN z.B. um 12 Uhr eingeschaltet, so tritt z.B. eine Einschaltstromspitze im Niederspannungsnetz NN auf. Diese sprunghafte Stromänderung wird im ersten Verfahrensschritt 1 von der Strommesseinheit SE um 12 Uhr festgestellt und im zweiten Verfahrensschritt 2 an die zentrale Kontrolleinheit KE gemeldet. Von der Kontrolleinheit KE werden im dritten Verfahrensschritt 3 die intelligenten Messeinheiten M1 bis M5 nach den von ihnen um 12 Uhr gemessenen Stromänderungen befragt. Haben zu diesem Zeitpunkt bei den zu den intelligenten Messeinheiten M1 bis M5 gehörenden Netzteilnehmern N1 bis N5 keine großen Verbrauchs- bzw. Stromänderungen (z.B. Ein- oder Ausschalten von Verbrauchern, etc.) stattgefunden, so werden die intelligenten Messeinheiten M1 bis M5 keine oder nur sehr geringe Stromänderungen an die zentrale Kontrolleinheit KE für den Zeitpunkt 12 Uhr zurückmelden. Im vierten Verfahrensschritt 4 wird von der zentralen Kontrolleinheit KE allerdings im Vergleich der Summe der von den intelligenten Messeinheiten M1 bis M5 gemessenen Stromänderungen mit der von der Strommesseinheit SE festgestellten Stromänderung eine Abweichung bzw. einen nicht zuordenbare Stromänderung für den Zeitpunkt 12 Uhr festgestellt werden. Es liegt damit ein eindeutiger Indikator für einen unrechtmäßigen Strombezug bzw. Stromdiebstahl nU vor.

In weiteren Verfahrensschritten können dann von der zentralen Kontrolleinheit KE weiterführende Analysemaßnahmen eingeleitet werden, um beispielsweise einen Bereich des Stromdiebstahls uN - z.B. erste Abzweig L1 - genauer einzugrenzen oder einen Ort des Stromdiebstahls uN - z.B. im Vorzählerbereich der intelligenten Messeinheit M2 - zu ermitteln. Bei einem defekten Zähler kann dieser z.B. ebenfalls durch die weiterführenden Analysemaßnahmen ermittelt werden und z.B. eine Reparatur oder ein Austausch veranlasst werden.

Dazu kann beispielsweise in einem fünften Verfahrensschritt 5 von der zentralen Kontrolleinheit KE eine Spannungsänderung für den Zeitpunkt der von der Strommesseinheit SE festgestellten Stromänderung (z.B. 12 Uhr) von den intelligenten Messeinheiten M1 bis M5 abgefragt werden. Jene intelligenten Messeinheiten M1, M2, von welchen die größte Spannungsänderung gemessen worden ist, ermöglichen dann - z.B. durch entsprechende Auswertung - eine Eingrenzung des Bereichs des Stromdiebstahls uN. In einem sechsten Verfahrensschritt 6 können die von den Messeinheiten M1 bis M5 festgestellten Spannungsänderungen auch an ein Auswertesystem AS weitergeleitet werden. Im Auswertesystem AS kann dann beispielsweise eine Verteilung der Spannungsänderung analysiert werden, um z.B. einen Tatort des Stromdiebstahls uN eindeutig feststellen zu können.

Bei Installation von Strommesseinheiten SE in mehreren Verteilerknoten VK - Transformatorstation und Verteilereinheiten - kann schon durch die Überwachung von z.B. einzelnen Abzweigen bzw. Leitungssträngen L1 bis L3 der Bereich des Stromdiebstahls uN genauer eingegrenzt bzw. der Ort des Stromdiebstahls uN genauer bestimmt werden. Dadurch ist gegebenenfalls eine Analyse von einer Spannungsänderung in einem Auswertesystem AS nicht mehr notwendig.

## Patentansprüche

1. Verfahren zum Erkennen von Stromdiebstahl (uN) in einem Niederspannungsnetz (NN), in welchem jedem bekannten Netzteilnehmer (N1 bis N5) eine intelligente Messeinheit (M1 bis M5) zugeordnet ist, wobei in zumindest einem Verteilerknoten (VK) des Niederspannungsnetzes (NN) eine Strommesseinheit (SE) installiert ist, und wobei intelligente Messeinheiten (M1 bis M5), sowie die zumindest eine Strommesseinheit (SE) von einer zentralen Kontrolleinheit (KE) überwacht werden, **dadurch gekennzeichnet, dass** von der zumindest einen Strommesseinheit (SE) auftretende Stromänderungen erfasst und mit einem vordefinierten Schwellwert verglichen werden (1), dass bei Überschreiten des vordefinierten Schwellwertes durch eine Stromänderung von der zumindest einen Strommesseinheit (SE) eine Meldung an die zentrale Kontrolleinheit (KE) gesendet wird (2), dass von der zentralen Kontrolleinheit (KE) für einen Zeitpunkt, an welchem die Stromänderung von der zumindest einen Strommesseinheit (SE) festgestellt worden ist, an den entsprechenden, intelligenten Messeinheiten (M1 bis M5) gemessene Stromänderungen abgefragt werden(3), dass von der zentralen Kontrolleinheit (KE) die von der zumindest einen Strommesseinheit (SE) festgestellte Stromänderung mit einer Summe der von den intelligenten Messeinheiten (M1 bis M5) gemessenen Stromänderungen verglichen wird (4), und dass bei einer Abweichung dieser Summe von der durch die zumindest eine Strommesseinheit (SE) festgestellten Stromänderung weiterführende Analysemaßnahmen eingeleitet werden (5, 6).

2. Verfahren nach Anspruch 1, **dadurch gekennzeichnet, dass** die zumindest eine Strommesseinheit (SE) und die intelligenten Messeinheiten (M1 bis M5) im Niederspannungsnetz (NN) mit Hilfe der zentralen Kontrolleinheit (KE) zeitlich synchronisiert werden.

3. Verfahren nach einem der Ansprüche 1 bis 2, **dadurch gekennzeichnet, dass** von der Meldung der zumindest einen Strommesseinheit (SE) an die zentrale Kontrolleinheit (KE) zumindest Informationen über die festgestellte Stromänderung und über den Zeitpunkt der festgestellten Stromänderung umfasst werden (2).

4. Verfahren nach einem der Ansprüche 1 bis 3, **dadurch gekennzeichnet, dass** als weiterführende Analysemaßnahmen von der zentralen Kontrolleinheit (KE) an den entsprechenden, intelligenten Messeinheiten (M1 bis M5) festgestellte Spannungsänderungen für den Zeitpunkt der von der zumindest einen Strommesseinheit (SE) festgestellten Stromänderung abgefragt werden (5).

5. Verfahren nach Anspruch 4, **dadurch gekennzeichnet, dass** eine Verteilung der von den intelligenten Messeinheiten (M1 bis M5) festgestellten Spannungsänderungen in einem Auswertsystem (AS) analysiert wird (6).

6. Verfahren nach einem der Ansprüche 1 bis 5, **dadurch gekennzeichnet, dass** für eine Kommunikation und/oder Datenübertragung zwischen den intelligenten Messeinheiten (M1 bis M5), der zumindest einen Strommesseinheit (SE) und der zentralen Kontrolleinheit (KE) das Niederspannungsnetz (NN) als Kommunikationsmedium, insbesondere eine so genannte Powerline Communication oder PLC, eingesetzt wird.

7. Verfahren nach einem der Ansprüche 1 bis 6, **dadurch gekennzeichnet, dass** als Verteilerknoten (VK), in welchen die zumindest eine Strommesseinheit (SE) installiert wird, Transformatorstationen und/oder Verteilereinheiten, insbesondere bei größeren Gebäudeeinheiten oder Gruppen von Netzteilnehmern (N1 bis N5), verwendet werden.
